# EUROPEAN PATENT SPECIFICATION

(11) **EP 4 401 313 B1**
(45) Date of publication and mention of the grant of the patent: **05.08.2026**
(21) Application number: 24151521.2
(22) Date of filing: 12.01.2024
(51) Int. Cl.: H03K 17/16, H03K 17/04, H02M 1/08, H03K 17/0412, H02M 1/00

(54) **PHOTOVOLTAIC INVERTER, DIRECT CURRENT CONVERSION CIRCUIT, AND INVERTER CIRCUIT**
FOTOVOLTAISCHER WECHSELRICHTER, GLEICHSTROMWANDLERSCHALTUNG UND WECHSELRICHTERSCHALTUNG
ONDULEUR PHOTOVOLTAÏQUE, CIRCUIT DE CONVERSION DE COURANT CONTINU ET CIRCUIT ONDULEUR

(30) Priority: 13.01.2023 CN 202310078892
(43) Date of publication of application: 17.07.2024
(73) Proprietor: Huawei Digital Power Technologies Co., Ltd., Shenzhen, 518043 (CN)
(72) Inventor: LI, Luo, Shenzhen 518043 (CN); SONG, Zhengang, Shenzhen 518043 (CN)
(74) Representative: Epping - Hermann - Fischer

(56) References cited:
- WO-A1-2016/031037
- US-A- 5 838 185
- US-A1- 2018 152 113
- US-B2- 8 212 409
- HENRY W OTT: "Noise reduction techniques in electronic systems", 1 January 1988, A WILEY INTERSCIENCE PUBLICATION, JOHN WILEY & SONS, PAGE(S) 1 - 225, pages: 73 - 129, XP007919490
- INFINEON TECHNICAL STAFF: "TRENCHSTOP 5 IGBT in a Kelvin Emitter Configuration", 16 October 2014 (2014-10-16), Retrieved from the Internet <URL:https://www.infineon.com/dgdl/Infineon-TRENCHSTOP5_in_TO-247-4pin-ApplicationNotes-v01_00-EN.pdf?fileId=5546d4624933b875014974f4d97e09ea> [retrieved on 20250416]

## Description

### TECHNICAL FIELD

This application relates to the field of power electronics, and in particular, to a photovoltaic inverter, a direct current conversion circuit, and an inverter circuit.

### BACKGROUND

For power supply equipment (such as a switching power supply and an inverter), efficiency and thermal design are important aspects in design of the power supply equipment. Power devices (such as various switch transistors and transistors) are key components in the power supply equipment. Loss reduction of the power devices plays a key role in the efficiency and thermal design of the power supply equipment. So far, most switch transistors and transistors are three-pin (or 3PIN) devices with a drive part compared with diodes. For a three-pin device, interaction between a power loop and a drive voltage signal is more sensitive. For example, in each switching cycle (on or off), stray inductance of a source or an emitter of a switch transistor plus switch current slope generates a voltage signal opposite to a drive voltage signal of a transistor, which reduces a switching speed of the switch transistor and increases a switching loss of each switching cycle, resulting in an increase in heat consumption of power supply equipment. Therefore, how to resolve a problem of an increase of a working loss of the power supply equipment due to reduction of the switching speed of the switch transistor caused by interaction between the power loop and the drive voltage signal of the switch transistor and the transistor in the power supply equipment is one of the technical problems that need to be urgently resolved currently.

US 8 212 409 B2 relates to a method of controlling a Multi-String inverter for a plurality of photovoltaic generator strings of a photovoltaic plant, said Multi-String inverter incorporating one separate DC-DC converter for each photovoltaic generator string on its input side, each output of said DC-DC converters being connected in parallel and with an input of a DC-AC converter and said DC-AC converter being configured to be connected to an alternating current mains for feeding into the mains, comprising: measuring an input current, input voltage and/or input power at each DC-DC converter, thereby generating measured input parameters; and changing an operating condition of at least one of the DC-DC converters based upon a comparison of the measured input parameters of at least two of the DC-DC converters.

US 5 838 185 A relates to a driving circuit for driving a load, comprising a top rail and a bottom rail and at least one transistor arranged along the bottom rail; an integrated circuit driver coupled to and serving for turning the at least one switching transistor at the bottom rail on and off, wherein the integrated circuit driver has a COM pin and includes at least one parasitic diode; and wherein each of at least one switching transistor at the bottom rail has an emitter connected to the bottom rail by a trace and has associated therewith a respective parasitic inductance relating to the length of the trace; and wherein the at least one switching transistor at the bottom rail is provided with an individual Kelvin emitter connection from the COM pin of the integrated circuit driver to the emitter of the transistor to reduce the parasitic inductance, as seen by the integrated circuit driver, which is associated with the at least one bottom rail switching transistor and which relates to the length of the trace of the connection between the emitter and the bottom rail.

US 2018/152113 Al relates to a half-bridge power module comprising a pair of transistor dies connected to positive, negative, and AC conductive tracks for carrying bridge currents; a pair of gate drive pins; and a pair of gate drive coils connecting a respective pin and die, wherein the gate drive coils are disposed in a region between the positive and negative tracks containing a flux generated by the currents having a locally greatest rate of change..

WO 2016/031037 Al relates to an inverter equipped with: a first transistor connected between a first input terminal and an output terminal; a second transistor connected between the output terminal and a second input terminal; first and second diodes connected in anti-parallel to the first and second transistors; and a bidirectional switch including third and fourth transistors and third and fourth diodes, and connected between a third input terminal (T3) and the output terminal. The first and second transistors and the third and fourth diodes are formed from a wide-bandgap semiconductor, while the third and fourth transistors and the first and second diodes are formed from a semiconductor other than a wide-bandgap semiconductor.

### SUMMARY

Embodiments of this application provide a photovoltaic inverter, and an inverter circuit, to avoid interference on a drive voltage by parasitic inductance generated based on a power current of a switch transistor, thereby increasing an overall switching speed of the switch transistor in the photovoltaic inverter, and reducing a working loss of the photovoltaic inverter.

According to a first aspect, this application provides an inverter circuit according to claim 1.

In this application, parasitic inductance generated at the emitter of the four-pin switch transistor in the inverter circuit does not affect a drive voltage that is built up between the Kelvin emitter and the gate. In this case, the drive voltage is built up at a higher speed, and the four-pin switch transistor is turned on or turned off at a higher speed, increasing an overall switching speed of the switch transistor in the inverter circuit. In addition, a switching cycle of the switch transistor has a lower loss, reducing a working loss of the inverter circuit to reduce a working loss of the photovoltaic inverter. Therefore, the photovoltaic inverter has strong working reliability.

By adding the additional resistor or the additional inductor, impedance of a transmission line between the drive units is much greater than impedance of a connection line between the corresponding switch transistors (or a ratio of impedance of a transmission line between the drive units to impedance of a connection line between the switch transistors may be not less than a preset impedance ratio), so that a power current shunted and outputted by a Kelvin emitter is reduced when the four-pin switch transistor is turned on or turned off, thereby preventing the power current shunted and outputted by the Kelvin emitter of the four-pin switch transistor in the inverter circuit from affecting the build-up of the drive voltage of the switch transistor and the switching speed of the switch transistor.

A drive voltage (or a drive signal) of the four-pin switch transistor is separated from a power current, which avoids interference on the drive voltage by parasitic inductance generated based on a power current of the emitter or the source. In this case, a build-up speed of the drive voltage and a turn-on or turn-off speed are higher, increasing an overall switching speed of the switch transistor in the photovoltaic inverter. In addition, a switching cycle of the switch transistor has a lower loss.

According to a second aspect, this application provides a photovoltaic inverter according to claim 2. In the following, parts of the description and drawings referring to embodiments which are not covered by the claims are not presented as embodiments of the invention, but as examples useful for understanding the invention.

### BRIEF DESCRIPTION OF DRAWINGS

FIG. 1 is a schematic diagram of an application scenario of a grid power supply system according to this application;
FIG. 2 is a schematic diagram of a structure of a four-pin switch transistor;
FIG. 3 is a schematic diagram of a structure of a grid power supply system according to this application;
FIG. 4 is a schematic diagram of a structure of a direct current conversion circuit according to this application;
FIG. 5 is a schematic diagram of another structure of a direct current conversion circuit according to this application;
FIG. 6a is a schematic diagram of another structure of a direct current conversion circuit according to this application;
FIG. 6b is a schematic diagram of another structure of a direct current conversion circuit according to this application;
FIG. 7 is a schematic diagram of a structure of an inverter circuit according to this application;
FIG. 8a is a schematic diagram of another structure of an inverter circuit according to this application;
FIG. 8b is a schematic diagram of another structure of an inverter circuit according to this application; and
FIG. 9 is a schematic diagram of a structure of a photovoltaic inverter according to this application.

### DESCRIPTION OF EMBODIMENTS

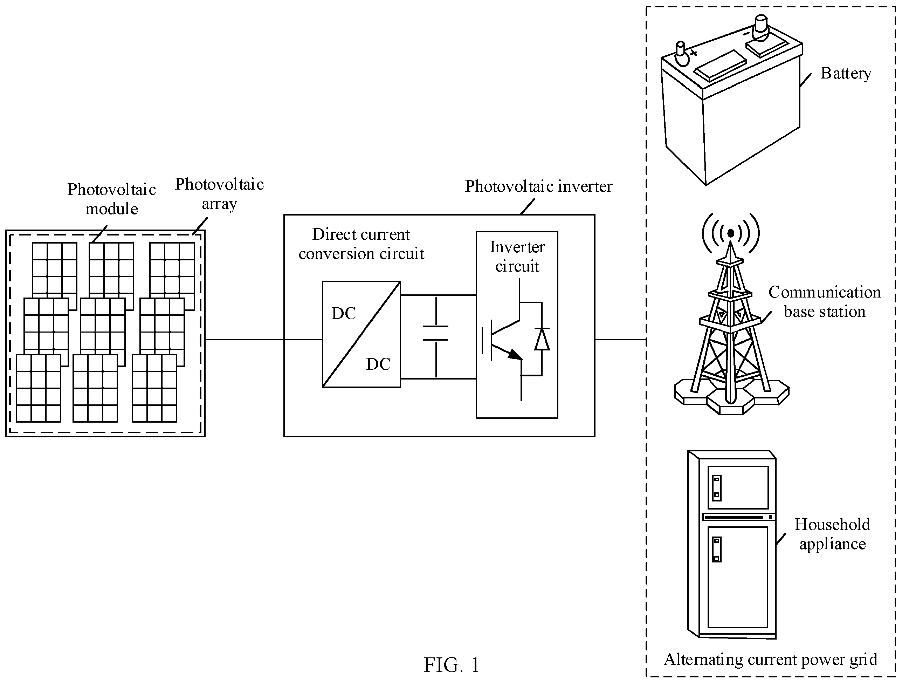

FIG. 1 is a schematic diagram of an application scenario of a grid power supply system according to this application. The grid power supply system provided in this application may include a direct current power supply and a photovoltaic inverter. The direct current power supply may be formed by a photovoltaic array. An output end of the photovoltaic array may be connected to an input end of the photovoltaic inverter, and an output end of the photovoltaic inverter is connected to an alternating current power grid. In the grid power supply system shown in FIG. 1, the photovoltaic array may be formed by one or more photovoltaic strings connected in parallel, and one photovoltaic string may be obtained by connecting one or more photovoltaic modules in series. The photovoltaic inverter may change (step up or step down) a direct current provided by the photovoltaic array by using a direct current conversion circuit, and perform voltage inversion conversion on the direct current with a voltage transformed by using an inverter circuit to supply power to electrical equipment such as a battery, a communication base station, or a household appliance in the alternating current power grid.

In the application scenario shown in FIG. 1, when the grid power supply system supplies power to the alternating current power grid, the photovoltaic inverter may include a plurality of switch transistors (which may be a metal-oxide-semiconductor field-effect transistor (MOSFET), MOS transistor for short, or may be an insulated gate bipolar transistor (insulated gate bipolar transistor, IGBT)). In a working process of the photovoltaic inverter of the grid power supply system, each switch transistor in the photovoltaic inverter may be turned on or turned off based on a received drive signal (for example, a pulse width modulation (Pulse Width Modulation, PWM) signal). Herein, most switch transistors in the photovoltaic inverter are three-pin (or 3PIN) devices with a drive part compared with diodes. For a three-pin device, there is an interaction problem between a power loop and a drive voltage signal. For example, using an IGBT transistor including three pins as an example, in each switching cycle (on or off) of the switch transistor, because parasitic inductance (or stray inductance) is generated at an emitter of the switch transistor due to change of a current (or change of a power current of a power loop) on the emitter of the switch transistor, and the parasitic inductance of the emitter of the switch transistor plus switch current slope generates a voltage signal opposite to a drive voltage signal, the build-up of a drive voltage between a gate and the emitter of the switch transistor is affected, consequently reducing a switching speed of the switch transistor and increasing a switching loss of each switching cycle. In a turn-on or turn-off process of each IGBT transistor or MOS transistor that includes three pins in the photovoltaic inverter, an overall switching speed of the switch transistor is reduced due to the interaction between the power loop and the drive voltage signal, which increases a working loss of the photovoltaic inverter. Consequently, the photovoltaic inverter has low working reliability.

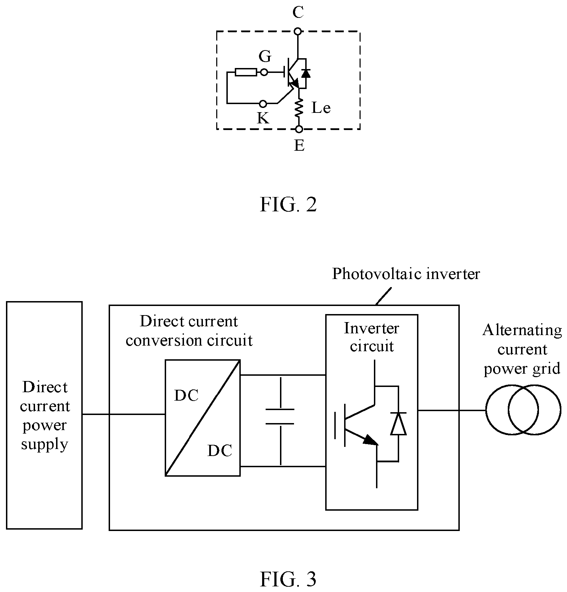

In the grid power supply system provided in this application, the photovoltaic inverter includes a direct current conversion circuit and an inverter circuit. An input end of the direct current conversion circuit is configured to connect to a direct current power supply. An output end of the direct current conversion circuit is configured to connect to an input end of the inverter circuit. An output end of the inverter circuit is configured to couple to an alternating current power grid. The direct current conversion circuit and the inverter circuit may include a plurality of switch transistors, and the direct current conversion circuit and the inverter circuit include at least one four-pin (or 4PIN) switch transistor. The four-pin switch transistor may be a four-pin switch transistor having a Kelvin structure. FIG. 2 is a schematic diagram of a structure of a four-pin switch transistor. The four-pin switch transistor shown in FIG. 2 is a four-pin IGBT transistor, and the four-pin IGBT transistor includes an emitter E, a gate G, a collector C, and a Kelvin emitter K. A drive voltage may be received between the gate G and the Kelvin emitter K of the four-pin IGBT transistor (which may be a drive voltage applied by a drive unit in a photovoltaic inverter to the four-pin IGBT transistor). The four-pin IGBT transistor may be turned on or turned off based on the drive voltage. In a turn-on or turn-off process, a changing power current (which may gradually increase or decrease) may be generated at the emitter E of the four-pin IGBT transistor, so that parasitic inductance Le is generated at the emitter. The parasitic inductance Le is separated from the drive voltage. The drive voltage (or the drive signal) of the four-pin IGBT transistor is separated from the power current, which avoids interference on the drive voltage by the parasitic inductance generated based on the power current of the emitter E. In this case, a build-up speed of the drive voltage between the gate and the emitter and a turn-on or turn-off speed are higher. Similarly, a process in which a four-pin MOS transistor separates a drive voltage (or a drive signal) and a power current is similar to that of the four-pin IGBT transistor, and details are not described herein again. In the photovoltaic inverter including the four-pin switch transistor (the four-pin IGBT transistor, the four-pin MOS transistor, and the like), an overall switching speed of the switch transistor is higher, and a loss of a switching cycle of the switch transistor is lower, reducing a working loss of the photovoltaic inverter. Therefore, the photovoltaic inverter has strong working reliability.

FIG. 3 is a schematic diagram of a structure of a grid power supply system according to this application. The grid power supply system shown in FIG. 3 includes a direct current power supply and a photovoltaic inverter. The direct current power supply may be a solar panel. An input end of the photovoltaic inverter is coupled to the direct current power supply in the grid power supply system, and an output end of the photovoltaic inverter is connected to an alternating current power grid. In the grid power supply system shown in FIG. 3, the direct current power supply is configured to provide an energy input or a power input for the photovoltaic inverter. The photovoltaic inverter may change (step up or step down) a direct current provided by a photovoltaic array by using a direct current conversion circuit, and perform voltage inversion conversion on the direct current with a voltage transformed by using an inverter circuit to supply power to electrical equipment such as a battery, a communication base station, or a household appliance in the alternating current power grid.

In some feasible implementations, in the grid power supply system shown in FIG. 3, the direct current conversion circuit and the inverter circuit in the photovoltaic inverter may include a plurality of switch transistors, and the direct current conversion circuit and the inverter circuit may include at least one four-pin (or 4PIN) switch transistor. The four-pin switch transistor may be a four-pin switch transistor (a four-pin IGBT transistor, a four-pin MOS transistor, or the like) having a Kelvin structure. In a working process of the photovoltaic inverter, a drive voltage may be applied (or a drive signal may be sent) to the plurality of switch transistors in the direct current conversion circuit and the inverter circuit by using a drive unit (which is not shown in FIG. 3 and may be based on the power supply of a drive power supply). The four-pin switch transistor (the four-pin IGBT transistor, the four-pin MOS transistor, or the like) may receive the drive voltage applied by the drive unit (which may be between a gate and a Kelvin emitter or may be between a gate and a Kelvin source). The four-pin switch transistor may be turned on or turned off based on the drive voltage. In a turn-on or turn-off process, a changing power current (which may gradually increase or decrease) may be generated at an emitter or a source of the four-pin switch transistor, so that parasitic inductance is generated at the emitter or the source. The parasitic inductance is separated from the drive voltage. The drive voltage (or the drive signal) of the four-pin switch transistor is separated from the power current, which avoids interference on the drive voltage by the parasitic inductance generated based on the power current of the emitter or the source. In this case, a build-up speed of the drive voltage and a turn-on or turn-off speed are higher, increasing an overall switching speed of the switch transistor in the photovoltaic inverter. In addition, a switching cycle of the switch transistor has a lower loss, reducing a working loss of the photovoltaic inverter. Therefore, the photovoltaic inverter has strong working reliability.

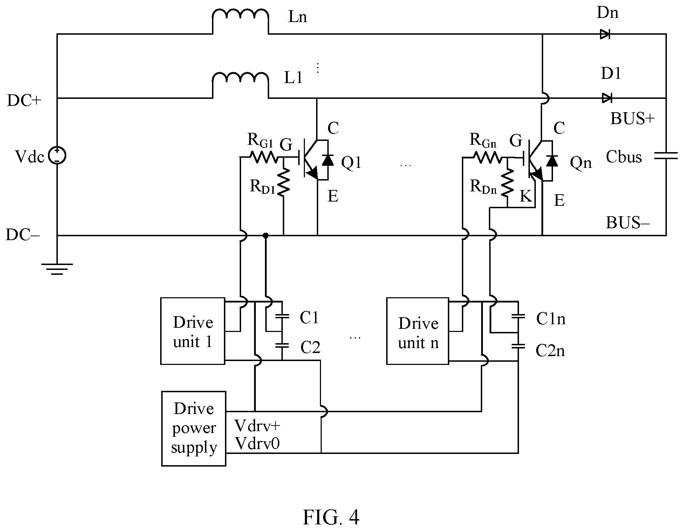

The following describes, with reference to FIG. 4 to FIG. 9, examples of a direct current conversion circuit and an inverter circuit provided in embodiments of this application. In some feasible implementations, the direct current conversion circuit may include a plurality of direct current conversion units and output capacitors that are connected in parallel, and each direct current conversion unit in the direct current conversion circuit may include a switch transistor, an inductor, and a diode. FIG. 4 is a schematic diagram of a structure of a direct current conversion circuit according to this application. As shown in FIG. 4, the direct current conversion circuit in FIG. 4 includes a plurality of direct current conversion units (which may include n direct current conversion units in total, including a direct current conversion unit 1 to a direct current conversion unit n). The direct current conversion circuit further includes a drive power supply and a plurality of drive units (which may include n drive units in total, including a drive unit 1 to a drive unit n, where a first input end and a second input end of each drive unit are respectively connected to a positive electrode and a negative electrode of the drive power supply). A switch transistor (which may be represented as a switch transistor Q1 for ease of description) in the direct current conversion unit 1 may be an IGBT transistor. A first end of the switch transistor Q1 (or a gate G of the switch transistor Q1) may be connected to an output end of the drive unit 1. A second end of the switch transistor Q1 (or an emitter E of the switch transistor Q1) is grounded. A third end of the switch transistor Q1 (or a collector C of the switch transistor Q1) may be connected to a direct current power supply by using an inductor (which may be represented as an inductor L1 for ease of description) in the direct current conversion unit 1. The third end of the switch transistor Q1 may alternatively be connected to an output capacitor (which may be represented as a capacitor Cbus for ease of description) in the direct current conversion circuit by using a diode (which may be represented as a diode D1 for ease of description) in the direct current conversion unit 1. It may be understood that a circuit structure of another direct current conversion unit in the direct current conversion circuit is the same as that of the direct current conversion unit 1, and details are not described herein again.

In some feasible implementations, in the plurality of direct current conversion units of the direct current conversion circuit shown in FIG. 4, a switch transistor included in at least one direct current conversion unit (which may be a target direct current conversion unit) is a four-pin switch transistor (for example, a four-pin IGBT transistor). Refer to FIG. 4 again. The direct current conversion unit n in FIG. 4 may be a target direct current conversion unit, the direct current conversion unit n includes a switch transistor Qn, and the switch transistor Qn may be a four-pin switch transistor (for example, a four-pin IGBT transistor). A fourth end of the switch transistor Qn (or a Kelvin emitter K of the switch transistor Qn) is connected to a first end of the switch transistor Qn (or a gate G of the switch transistor Qn) and a second end of the switch transistor Qn (or an emitter E of the switch transistor Qn). The fourth end of the switch transistor Qn is coupled to a first input end of the drive unit n by using a capacitor C1n. The fourth end of the switch transistor Qn is coupled to a second input end of the drive unit n by using a capacitor C2n. It may be understood that the direct current conversion circuit may further include another target direct current conversion unit other than the direct current conversion unit n. A connection relationship between a four-pin switch transistor in another target direct current conversion unit and a corresponding target drive unit is the same as that in the direct current conversion unit n, and details are not described herein again. In a working process of the direct current conversion circuit, a drive voltage may be applied (or a drive signal may be sent) to the plurality of switch transistors in the direct current conversion circuit by using the plurality of drive units included in the direct current conversion circuit. The four-pin switch transistor in the target direct current conversion unit may receive a drive voltage applied by a corresponding target drive unit (which may be between a gate and a Kelvin emitter or may be between a gate and a Kelvin source). Using the direct current conversion unit n in FIG. 4 as an example, the drive unit n may apply a drive voltage between the first end of the switch transistor Qn (or the gate G of the switch transistor Qn) and the fourth end of the switch transistor Qn (or the Kelvin emitter K of the switch transistor Qn) based on the power supply of the drive power supply. The switch transistor Qn may be turned on or turned off based on the drive voltage. In a turn-on or turn-off process, a changing power current (which may gradually increase or decrease) may be generated at the second end of the switch transistor Qn (or the emitter E of the switch transistor Qn), so that parasitic inductance is generated at the second end of the switch transistor Qn. Herein, the drive voltage (or the drive signal) is separated from the power current through the fourth end of the switch transistor Qn. A turn-on or turn-off process of a four-pin switch transistor in another target direct current conversion unit based on a drive voltage applied by a corresponding target drive unit is the same as that of the switch transistor Qn, and details are not described herein again. Parasitic inductance generated at the second end of the four-pin switch transistor in the direct current conversion circuit does not affect a drive voltage that is built up between the fourth end and the first end. In this case, the drive voltage is built up at a higher speed, and the four-pin switch transistor is turned on or turned off at a higher speed, increasing an overall switching speed of the switch transistor in the direct current conversion circuit. In addition, a switching cycle of the switch transistor has a lower loss, reducing a working loss of the direct current conversion circuit to reduce a working loss of the photovoltaic inverter. Therefore, the photovoltaic inverter has strong working reliability. It may be understood that the four-pin switch transistor included in the direct current conversion circuit in FIG. 4 may alternatively be a four-pin MOS transistor. A fourth end of the four-pin MOS transistor (or a Kelvin source of the switch transistor) is connected to a first end of the switch transistor (or a gate of the switch transistor) and a second end of the switch transistor (or a source of the switch transistor), and a connection relationship between the four-pin MOS transistor and another device in the direct current conversion circuit is the same as that of the four-pin IGBT transistor, and details are not described herein again.

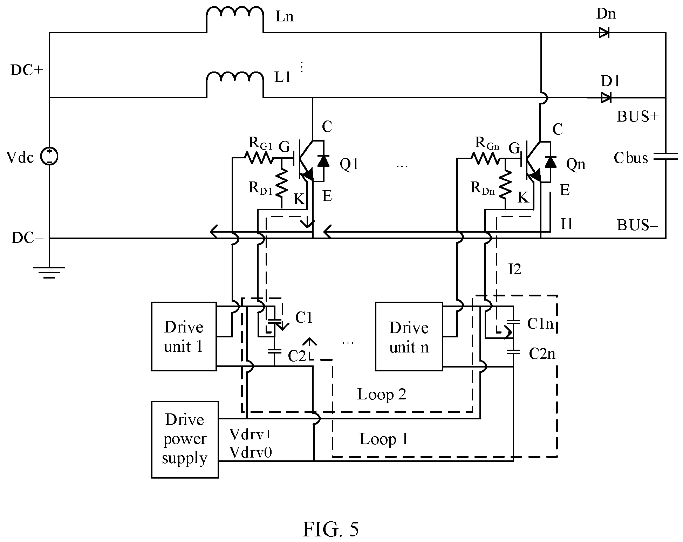

In some feasible implementations, FIG. 5 is a schematic diagram of another structure of a direct current conversion circuit according to this application. As shown in FIG. 5, the direct current conversion circuit in FIG. 5 includes a plurality of direct current conversion units (which may include n direct current conversion units in total, including a direct current conversion unit 1 to a direct current conversion unit n). The direct current conversion circuit further includes a drive power supply and a plurality of drive units (which may include n drive units in total, including a drive unit 1 to a drive unit n, where a first input end and a second input end of each drive unit are respectively connected to a positive electrode and a negative electrode of the drive power supply). A switch transistor included in each direct current conversion unit in FIG. 5 is a four-pin switch transistor (which may be a four-pin IGBT transistor or a four-pin MOS transistor). A connection relationship between each four-pin switch transistor and a corresponding drive unit is the same as that of the four-pin switch transistor in FIG. 4, and a turn-on or turn-off process based on a drive voltage applied by the corresponding drive unit is the same as that of the four-pin switch transistor in FIG. 4, and details are not described herein again. For example, a switch transistor included in each direct current conversion unit in FIG. 5 is a four-pin IGBT transistor. The drive unit n may apply a drive voltage between a first end of a switch transistor Qn (or a gate G of the switch transistor Qn) and a fourth end of the switch transistor Qn (or a Kelvin emitter K of the switch transistor Qn) in the direct current conversion unit n based on the power supply of the drive power supply. The switch transistor Qn may be turned on or turned off based on the drive voltage. In a turn-on process based on the drive voltage, the switch transistor may be turned on between a second end of the switch transistor (or an emitter E of the switch transistor Qn) and a third end of the switch transistor (or a collector C of the switch transistor Qn), and the emitter E of the switch transistor Qn may output a power current I1. Herein, as emitters E of switch transistors in the direct current conversion circuit are connected to each other (commonly grounded), and the drive units are connected to a drive power supply, the Kelvin emitter K of the switch transistor Qn is connected to an emitter E of another switch transistor by using the drive unit n. In this case, the Kelvin emitter K of the switch transistor Qn can shunt and output a power current I2 (where the current is far less than the power current I1). The power current I2 may flow through a connection line between the drive unit n and another drive unit to an emitter E of another switch transistor other than the switch transistor Qn. For example, the power current I2 outputted from the Kelvin emitter K of the switch transistor Qn flows to a switch transistor Q1 in the direct current conversion unit 1. The power current I2 may flow to an emitter E of the switch transistor Q1 through a loop 1 and a loop 2. The loop 1 includes that the power current I2 flows from the Kelvin emitter K of the switch transistor Qn to a capacitor C2n connected to the drive unit n, flows through the capacitor C2n to a capacitor C2 connected to the drive unit 1, and flows through the capacitor C2 to a Kelvin emitter K of the switch transistor Q1 to flow to the emitter E. The loop 2 includes that the power current I2 flows from the Kelvin emitter K of the switch transistor Qn to a capacitor C1n connected to the drive unit n, flows through the capacitor C1n to a capacitor C1 connected to the drive unit 1, and flows through the capacitor C1 to the Kelvin emitter K of the switch transistor Q1 to flow to the emitter E. The power current I2 shunted by the Kelvin emitter K of the switch transistor Qn flows to the emitter E of the switch transistor Q1 through a connection line between the drive unit n and the drive unit 1. In this case, when the drive unit 1 applies a drive voltage to the switch transistor Q1 (which may be between a gate G and the Kelvin emitter K of the switch transistor Q1), the power current I2 affects the build-up of the drive voltage on the switch transistor Q1, which reduces a switching speed of the switch transistor Q1 and increases a switching loss of a switching cycle. It may be understood that a process in which a power current shunted by a Kelvin emitter K in any four-pin switch transistor in FIG. 5 affects a drive voltage and a switching speed of another switch transistor other than the foregoing four-pin switch transistor is the same as a process of affecting the switch transistor Qn and the switch transistor Q1, and details are not described herein again.

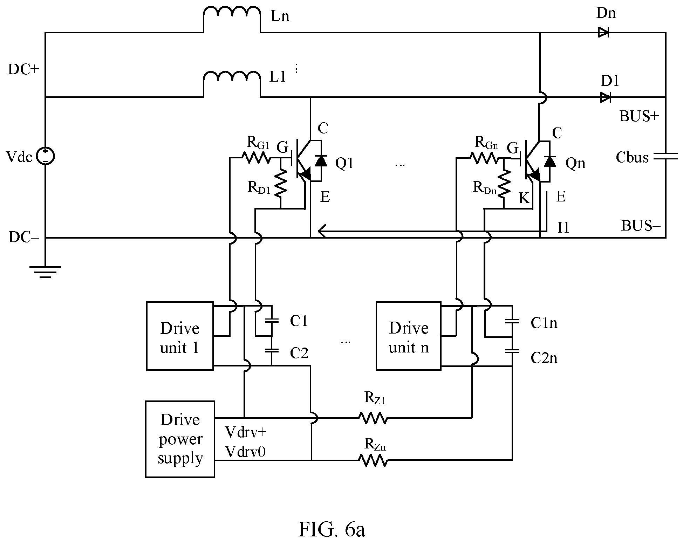

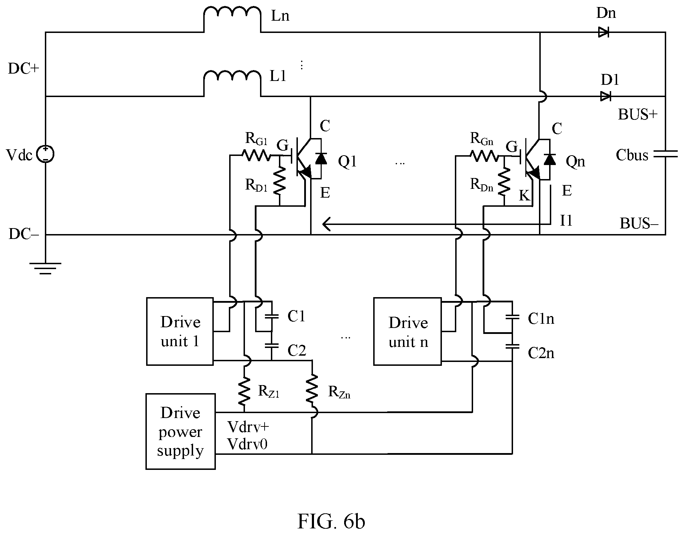

In some feasible implementations, each direct current conversion unit in the direct current conversion circuit shown in FIG. 4 or FIG. 5 may include an additional resistor or an additional inductor. A first input end and a second input end of any drive unit are coupled to a first input end and a second input end of another drive unit by using at least one additional resistor or by using at least one additional inductor. The direct current conversion circuit shown in FIG. 5 is used as an example for description. The drive unit n in FIG. 5 may be coupled to another drive unit by using the additional resistor or the additional inductor, to prevent a power current shunted and outputted by the Kelvin emitter K of the switch transistor Qn from affecting a switching speed of another switch transistor. FIG. 6a is a schematic diagram of another structure of a direct current conversion circuit according to this application. As shown in FIG. 6a, the direct current conversion circuit in FIG. 6a includes a plurality of direct current conversion units. For a circuit structure of each direct current conversion unit, refer to the direct current conversion circuit shown in FIG. 5. A first output end of a drive unit n may be connected to a positive electrode of a drive power supply by using a resistor RZ1. A second output end of the drive unit n may be connected to a negative electrode of the drive power supply by using a resistor RZ2. By using the resistor RZ1 and the resistor RZ2 between the drive unit n and a drive unit 1, impedance of a transmission line between first and second input ends of the drive unit n and first and second input ends of the drive unit 1 is much greater than impedance of a connection line between a switch transistor Qn and a switch transistor Q1 (or a ratio of impedance of a transmission line between first and second input ends of the drive unit n and first and second input ends of the drive unit 1 to impedance of a connection line between a switch transistor Qn and a switch transistor Q1 is not less than a preset impedance ratio), so that a power current shunted and outputted by a Kelvin emitter K of the switch transistor Qn is reduced when the switch transistor Qn is turned on or turned off, thereby preventing the power current shunted and outputted by the Kelvin emitter K of the switch transistor Qn from affecting the build-up of a drive voltage of the switch transistor Q1 and a switching speed of the switch transistor Q1. FIG. 6b is a schematic diagram of another structure of a direct current conversion circuit according to this application. As shown in FIG. 6b, the direct current conversion circuit in FIG. 6b includes a plurality of direct current conversion units. For a circuit structure of each direct current conversion unit, refer to the direct current conversion circuit shown in FIG. 5. A first output end of a drive unit 1 may be connected to a positive electrode of a drive power supply by using a resistor RZ1. A second output end of the drive unit 1 may be connected to a negative electrode of the drive power supply by using a resistor RZ2. By using the resistor RZ1 and the resistor RZ2 between the drive unit n and a drive power supply, impedance of a transmission line between first and second input ends of the drive unit n and first and second input ends of the drive unit 1 is much greater than impedance of a connection line between a switch transistor Qn and a switch transistor Q1 (or a ratio of impedance of a transmission line between first and second input ends of the drive unit n and first and second input ends of the drive unit 1 to impedance of a connection line between a switch transistor Qn and a switch transistor Q1 is not less than a preset impedance ratio), so that a power current shunted and outputted by a Kelvin emitter K of the switch transistor Qn is reduced when the switch transistor Qn is turned on or turned off, thereby preventing the power current shunted and outputted by the Kelvin emitter K of the switch transistor Qn from affecting the build-up of a drive voltage of the switch transistor Q1 and a switching speed of the switch transistor Q1. In the direct current conversion circuit shown in FIG. 6a or FIG. 6b, the drive unit n may be coupled to another drive unit by using an additional inductor to increase impedance of a transmission line. To be specific, the first output end of the drive unit n may be connected to the positive electrode of the drive power supply by using the inductor, and the second output end of the drive unit n may be connected to the negative electrode of the drive power supply by using the inductor, or the first output end and the second output end of the drive unit 1 may be respectively connected to the positive electrode and the negative electrode of the drive power supply by using the inductor. In addition, a resistor or an inductor may be formed between the drive unit n and another drive unit by PCB wiring to increase the impedance of the transmission line. This may be specifically determined according to an actual application scenario, and is not limited herein. It may be understood that, in the direct current conversion circuit shown in FIG. 4 or FIG. 5, for adding an additional resistor or an additional inductor between other drive units to increase impedance of a connection line between the drive units, refer to the connection manner between the drive unit n and the drive unit 1. Details are not described herein again. By adding the additional resistor or the additional inductor, impedance of a transmission line between the drive units is much greater than impedance of a connection line between the corresponding switch transistors (or a ratio of impedance of a transmission line between the drive units to impedance of a connection line between the switch transistors may be not less than a preset impedance ratio), so that a power current shunted and outputted by a Kelvin emitter or a Kelvin source is reduced when the four-pin switch transistor is turned on or turned off, thereby preventing the power current shunted and outputted by the Kelvin emitter or the Kelvin source of the four-pin switch transistor in the direct current conversion circuit from affecting the build-up of the drive voltage of the switch transistor and the switching speed of the switch transistor.

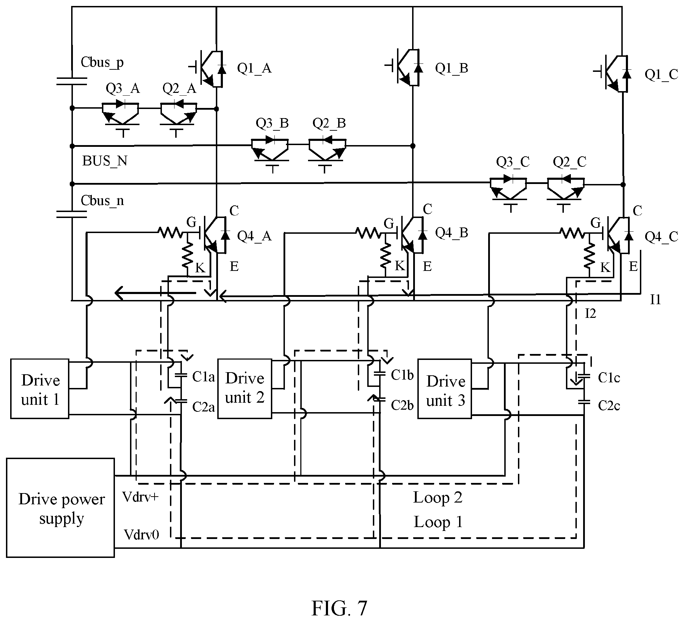

In some feasible implementations, the inverter circuit may include a plurality of inverter units, and each inverter unit may include a plurality of switch transistors. FIG. 7 is a schematic diagram of a structure of an inverter circuit according to this application. As shown in FIG. 7, the inverter circuit in FIG. 7 includes three inverter units (which may include an inverter unit 1, an inverter unit 2, and an inverter unit 3). The inverter circuit further includes a drive power supply and a plurality of drive units (which may include a drive unit 1, a drive unit 2, and a drive unit 3, where a first input end and a second input end of each drive unit are respectively connected to a positive electrode and a negative electrode of the drive power supply). An output end of any drive unit is connected to a first end of a switch transistor (which may be a target switch transistor) in a plurality of switch transistors of an inverter unit associated with the any drive unit. A target switch transistor included in at least one of the plurality of inverter units is a four-pin switch transistor. This application uses an example in which target switch transistors included in the plurality of inverter units are all four-pin switch transistors for description. The inverter circuit further includes a first direct current capacitor (which may be represented as a capacitor Cbus_n for ease of description) and a second direct current capacitor (which may be represented as a capacitor Cbus_p for ease of description) that are connected in series. Refer to FIG. 7 again. A target switch transistor (which may be represented as a switch transistor Q4_A for ease of description) connected to the drive unit 1 associated with the inverter unit 1 may be a four-pin IGBT transistor. An output end of the drive unit 1 is connected to a first end of the switch transistor Q4_A (or a gate G of the switch transistor Q4_A). A second end of the switch transistor Q4_A (or an emitter E of the switch transistor Q4_A) is connected to the capacitor Cbus_n. A third end of the switch transistor Q4_A (or a collector C of the switch transistor Q4_A) is connected to the second direct current capacitor by using a switch transistor (which may be represented as a switch transistor Q1_A for ease of description) in the inverter unit 1, and is connected to connection ends of the capacitor Cbus_n and the capacitor Cbus_p by using two switch transistors (which may be respectively represented as a switch transistor Q2_A and a switch transistor Q3_A for ease of description) connected in series in the inverter unit 1. A fourth end of the switch transistor Q4_A (or a Kelvin emitter K of the switch transistor Q4_A) is connected to the first end and the second end of the switch transistor. The fourth end of the switch transistor Q4_A is coupled to a first input end and a second input end of the drive unit 1. It may be understood that a circuit structure of another inverter unit in the inverter circuit is the same as that of the inverter unit 1, and details are not described herein again. In a working process of the inverter circuit, a drive voltage may be applied (or a drive signal may be sent) to the plurality of switch transistors in the inverter circuit by using the plurality of drive units included in the inverter circuit. The four-pin switch transistor in the inverter unit may receive a drive voltage applied by a corresponding drive unit (which may be between a gate and a Kelvin emitter or may be between a gate and a Kelvin source). Using the inverter unit 1 in FIG. 7 as an example, the drive unit 1 may apply a drive voltage between the first end of the switch transistor Q4_A (or the gate G of the switch transistor Q4_A) and the fourth end of the switch transistor Q4_A (or the Kelvin emitter K of the switch transistor Q4_A) based on the power supply of the drive power supply. The switch transistor Q4_A may be turned on or turned off based on the drive voltage. In a turn-on or turn-off process, a changing power current (which may gradually increase or decrease) may be generated at the second end of the switch transistor Q4_A (or the emitter E of the switch transistor Q4_A), so that parasitic inductance is generated at the second end of the switch transistor Q4_A. Herein, the drive voltage (or the drive signal) is separated from the power current through the fourth end of the switch transistor Q4_A. A turn-on or turn-off process of a four-pin switch transistor in another inverter unit based on a drive voltage applied by a corresponding drive unit is the same as that of the switch transistor Q4_A, and details are not described herein again. Parasitic inductance generated at the second end of the four-pin switch transistor in the inverter circuit does not affect a drive voltage that is built up between the fourth end and the first end. In this case, the drive voltage is built up at a higher speed, and the four-pin switch transistor is turned on or turned off at a higher speed, increasing an overall switching speed of the switch transistor in the inverter circuit. In addition, a switching cycle of the switch transistor has a lower loss, reducing a working loss of the inverter circuit to reduce a working loss of the photovoltaic inverter. Therefore, the photovoltaic inverter has strong working reliability. It may be understood that the four-pin switch transistor included in the direct current conversion circuit in FIG. 7 may alternatively be a four-pin MOS transistor. A fourth end of the four-pin MOS transistor (or a Kelvin source of the switch transistor) is connected to a first end of the switch transistor (or a gate of the switch transistor) and a second end of the switch transistor (or a source of the switch transistor), and a connection relationship between the four-pin MOS transistor and another device in the direct current conversion circuit is the same as that of the four-pin IGBT transistor, and details are not described herein again.

In some feasible implementations, in a process in which a four-pin switch transistor, for example, a switch transistor Q4_C, in the inverter circuit shown in FIG. 7 is turned on or turned off based on a drive voltage, the switch transistor Q4_C may be turned on between a second end of the switch transistor Q4_C (or an emitter E of the switch transistor Q4_C) and a third end of the switch transistor Q4_C (or a collector C of the switch transistor Q4_C), and the emitter E of the switch transistor Q4_C may output a power current I1. Herein, as emitters E of four-pin switch transistors in the inverter circuit are connected to each other (commonly connected to an end of the capacitor Cbus_n), and the drive units are connected to a drive power supply, a Kelvin emitter K of the switch transistor Q4_C is connected to an emitter E of another switch transistor by using the drive unit 3. In this case, the Kelvin emitter K of the switch transistor Q4_C can shunt and output a power current I2 (where the current is far less than the power current I1). The power current I2 may flow through a connection line between the drive unit 3 and another drive unit to an emitter E of another switch transistor other than the switch transistor Q4_C. For example, the power current I2 outputted from the Kelvin emitter K of the switch transistor Q4_C flows to a switch transistor Q4_B in the inverter unit 2. The power current I2 may flow to an emitter E of the switch transistor Q4_B through a loop 1 and a loop 2. The loop 1 includes that the power current I2 flows from the Kelvin emitter K of the switch transistor Q4_C to a capacitor C2c connected to the drive unit 3, flows through the capacitor C2c to a capacitor C2b connected to the drive unit 2, and flows through the capacitor C2b to a Kelvin emitter K of the switch transistor Q4_B to flow to the emitter E. The loop 2 includes that the power current I2 flows from the Kelvin emitter K of the switch transistor Q4_C to a capacitor C1c connected to the drive unit 3, flows through the capacitor C1c to a capacitor C1b connected to the drive unit 2, and flows through the capacitor C1b to the Kelvin emitter K of the switch transistor Q4_B to flow to the emitter E. The power current I2 shunted by the Kelvin emitter K of the switch transistor Q4_C flows to the emitter E of the switch transistor Q4_B through a connection line between the drive unit 3 and the drive unit 2. In this case, when the drive unit 2 applies a drive voltage to the switch transistor Q4_B (which may be between a gate G and the Kelvin emitter K of the switch transistor Q4_B), the power current I2 affects the build-up of the drive voltage on the switch transistor Q4_B, which reduces a switching speed of the switch transistor Q4_B and increases a switching loss of a switching cycle. It may be understood that a process in which a power current shunted by a Kelvin emitter K in any four-pin switch transistor in FIG. 7 affects a drive voltage and a switching speed of another switch transistor other than the four-pin switch transistor is the same as a process of affecting the switch transistor Q4_C and the switch transistor Q4_B, and details are not described herein again.

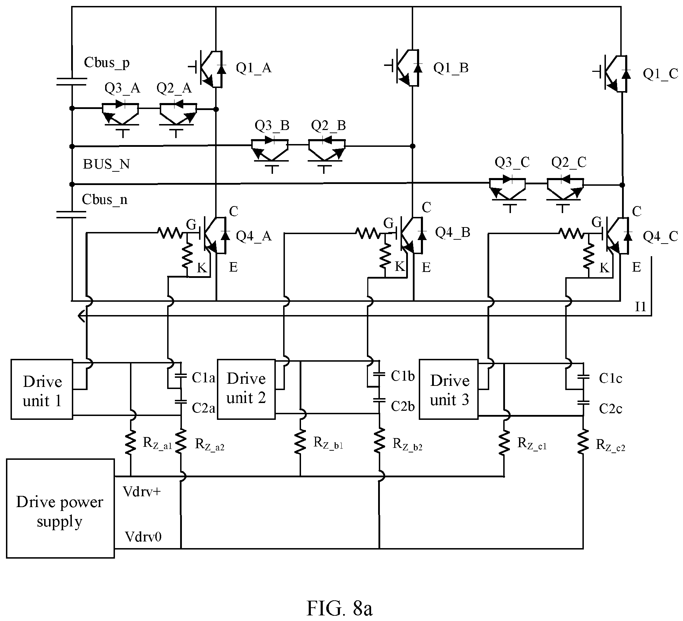

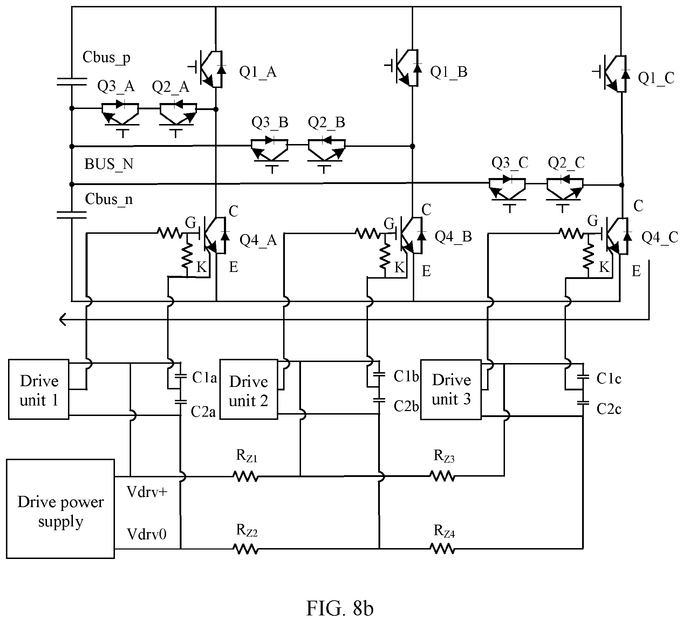

In some feasible implementations, each inverter unit in the inverter circuit shown in FIG. 7 may include an additional resistor or an additional inductor. A first input end and a second input end of the any drive unit are coupled to a first input end and a second input end of another drive unit by using at least one additional resistor or by using at least one additional inductor. The inverter circuit shown in FIG. 7 is used as an example for description. The drive unit 3 in FIG. 7 may be coupled to another drive unit by using the additional resistor or the additional inductor, to prevent a power current shunted and outputted by the Kelvin emitter K of the switch transistor Q4_C from affecting a switching speed of another switch transistor. FIG. 8a is a schematic diagram of another structure of an inverter circuit according to this application. As shown in FIG. 8a, the inverter circuit in FIG. 8a includes three inverter units. For a circuit structure of each inverter unit, refer to the inverter circuit shown in FIG. 7. A first output end and a second output end of a drive unit 1 may be respectively connected to a positive electrode and a negative electrode of a drive power supply by using a resistor RZ_a1 and a resistor RZ_a2. A first output end and a second output end of a drive unit 2 may be respectively connected to the positive electrode and the negative electrode of the drive power supply by using a resistor RZ_b1 and a resistor RZ_b2. A first output end and a second output end of a drive unit 3 may be respectively connected to the positive electrode and the negative electrode of the drive power supply by using a resistor RZ_cl and a resistor RZ_c2. Herein, by using a resistor between the drive unit 3 and the drive unit 1 and a resistor between the drive unit 3 and the drive unit 2, impedance of transmission lines between first and second input ends of the drive unit 3 and first and second input ends of the drive unit 1 and between the first and second input ends of the drive unit 3 and first and second input ends of the drive unit 2 is much greater than impedance of connection lines between the switch transistor Q4_C and the switch transistor Q4_A and between the switch transistor Q4_C and the switch transistor Q4_B (or a ratio of the impedance of the transmission line between the first and second input ends of the drive unit 3 and the first and second input ends of the drive unit 1 (or the drive unit 2) to the impedance of the connection line between the switch transistor Q4_C and the switch transistor Q4_A is not less than a preset impedance ratio), so that a power current shunted and outputted by the Kelvin emitter K of the switch transistor Q4_C when the switch transistor Q4_C is turned on or turned off, thereby preventing the power current shunted and outputted by the Kelvin emitter K of the switch transistor Q4_C from affecting the build-up of a drive voltage of a switch transistor 3 and a switching speed of the switch transistor 3. FIG. 8b is a schematic diagram of another structure of an inverter circuit according to this application. As shown in FIG. 8b, the inverter circuit in FIG. 8b includes three inverter units. For a circuit structure of each inverter unit, refer to the inverter circuit shown in FIG. 7. A first output end and a second output end of a drive unit 1 may be respectively connected to a first output end and a second output end of a drive unit 2 by using resistors RZ1 and RZ2. The first output end and the second output end of the drive unit 2 may be respectively connected to a first output end and a second output end of a drive unit 3 by using resistors RZ3 and RZ4. Herein, by using a resistor between the drive unit 3 and the drive unit 1 and a resistor between the drive unit 3 and the drive unit 2, impedance of transmission lines between first and second input ends of the drive unit 3 and first and second input ends of the drive unit 1 and between the first and second input ends of the drive unit 3 and first and second input ends of the drive unit 2 is much greater than impedance of connection lines between the switch transistor Q4_C and the switch transistor Q4_A and between the switch transistor Q4_C and the switch transistor Q4_B (or a ratio of the impedance of the transmission line between the first and second input ends of the drive unit 3 and the first and second input ends of the drive unit 1 (or the drive unit 2) to the impedance of the connection line between the switch transistor Q4_C and the switch transistor Q4_A is not less than a preset impedance ratio), so that a power current shunted and outputted by the Kelvin emitter K of the switch transistor Q4_C when the switch transistor Q4_C is turned on or turned off, thereby preventing the power current shunted and outputted by the Kelvin emitter K of the switch transistor Q4_C from affecting the build-up of a drive voltage of a switch transistor 3 and a switching speed of the switch transistor 3. In the inverter circuit shown in FIG. 8a or FIG. 8b, the drive unit 3 may be coupled to another drive unit by using an additional inductor to increase impedance of the transmission line. In addition, a resistor or an inductor may be formed between the drive unit 3 and another drive unit by PCB wiring to increase the impedance of the transmission line. This may be specifically determined according to an actual application scenario, and is not limited herein.

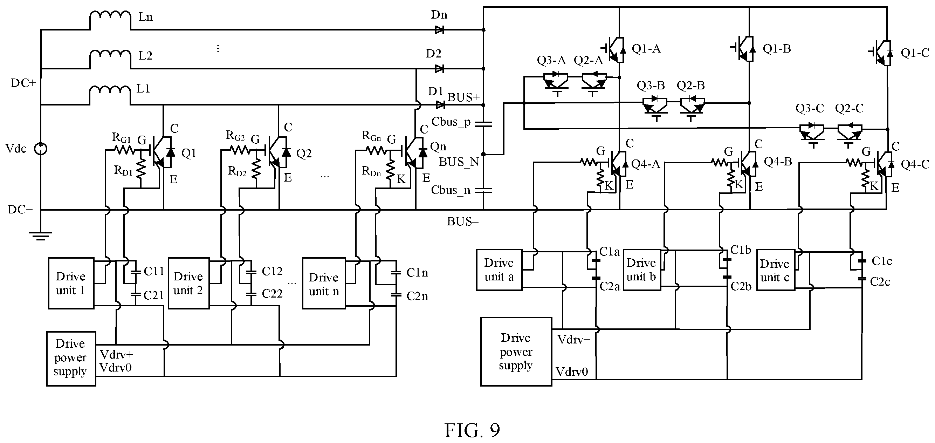

In some feasible implementations, FIG. 9 is a schematic diagram of a structure of a photovoltaic inverter according to this application. As shown in FIG. 9, the photovoltaic inverter in FIG. 9 includes a direct current conversion circuit and an inverter circuit. The direct current conversion circuit includes a plurality of direct current conversion units (which may include n direct current conversion units in total, including a direct current conversion unit 1 to a direct current conversion unit n). The direct current conversion circuit further includes a drive power supply and a plurality of drive units (which may include n drive units in total, including a drive unit 1 to a drive unit n, where a first input end and a second input end of each drive unit are respectively connected to a positive electrode and a negative electrode of the drive power supply). The direct current conversion units in FIG. 9 are the same as the direct current conversion units included in the direct current conversion circuit in FIG. 5, and details are not described herein again. The inverter circuit includes three inverter units (which may include an inverter unit 1, an inverter unit 2, and an inverter unit 3). The inverter circuit further includes a drive power supply and a plurality of drive units (which may include a drive unit a, a drive unit b, and a drive unit c, where a first input end and a second input end of each drive unit are respectively connected to a positive electrode and a negative electrode of the drive power supply). The inverter units in FIG. 9 are the same as the inverter units included in the inverter circuit in FIG. 7, and details are not described herein again. Herein, the direct current conversion circuit in FIG. 9 may be connected to the inverter circuit by using a first direct current capacitor (which may be represented as a capacitor Cbus_n for ease of description) and a second direct current capacitor (which may be represented as a capacitor Cbus_p for ease of description), and the capacitor Cbus_n and the capacitor Cbus_p are connected in series and then connected in parallel to two ends of a switch transistor included in each direct current conversion unit. At least one direct current conversion unit in the plurality of direct current conversion units includes a four-pin switch transistor (which may be that at least one direct current conversion unit in the direct current conversion unit 1 to the direct current conversion unit n includes a four-pin switch transistor). Alternatively, a target switch transistor included in at least one inverter unit in the plurality of inverter units is a four-pin switch transistor. A fourth end of the four-pin switch transistor is connected to a first end and a second end of the four-pin switch transistor. The fourth end of the four-pin switch transistor is coupled to a first input end and a second input end of a target drive unit connected to the at least one direct current conversion unit or the at least one inverter unit. The photovoltaic inverter may be configured to separate, through the fourth end of the four-pin switch transistor, a power current outputted from the second end of the four-pin switch transistor and a drive voltage applied by the target drive unit, to avoid interference on the drive voltage caused by parasitic inductance generated based on the power current. Further, each direct current conversion unit in the direct current conversion circuit and each inverter unit in the inverter circuit that are shown in FIG. 9 may include an additional resistor or an additional inductor. For a connection relationship between each direct current conversion unit and the additional resistor or the additional inductor, refer to the direct current conversion circuits shown in FIG. 6a and FIG. 6b. For a connection relationship between each inverter unit and the additional resistor or the additional inductor, refer to the inverter circuits shown in FIG. 8a and FIG. 8b. By adding the additional resistor or the additional inductor, impedance of a transmission line between the drive units is much greater than impedance of a connection line between the corresponding switch transistors (or a ratio of impedance of a transmission line between the drive units to impedance of a connection line between the switch transistors may be not less than a preset impedance ratio), so that a power current shunted and outputted by a Kelvin emitter or a Kelvin source is reduced when the four-pin switch transistor in the photovoltaic inverter is turned on or turned off, thereby preventing the power current shunted and outputted by the Kelvin emitter or the Kelvin source of the four-pin switch transistor in the photovoltaic inverter from affecting the build-up of the drive voltage of the switch transistor and the switching speed of the switch transistor.

In this application, the photovoltaic inverter includes a direct current conversion circuit and an inverter circuit. An input end of the direct current conversion circuit is configured to connect to a direct current power supply. An output end of the direct current conversion circuit is configured to connect to an input end of the inverter circuit. An output end of the inverter circuit is configured to couple to an alternating current power grid. The direct current conversion circuit and the inverter circuit may include a plurality of switch transistors, and the direct current conversion circuit and the inverter circuit include at least one four-pin (or 4PIN) switch transistor. The four-pin switch transistor may be a four-pin switch transistor having a Kelvin structure. A drive voltage may be received between a first end and a fourth end of the four-pin switch transistor (which may be a drive voltage applied by a drive unit in the photovoltaic inverter to the four-pin switch transistor). The four-pin switch transistor may be turned on or turned off based on the drive voltage. In a turn-on or turn-off process, a changing power current (which may gradually increase or decrease) may be generated at a second end of the four-pin switch transistor, so that parasitic inductance is generated at an emitter. The four-pin switch transistor may separate the parasitic inductance from the drive voltage through the fourth end (a Kelvin emitter or a Kelvin source). The drive voltage (or the drive signal) of the four-pin switch transistor is separated from the power current, which avoids interference on the drive voltage by the parasitic inductance generated based on the power current. In this case, a build-up speed of the drive voltage and a turn-on or turn-off speed are higher, and a loss of an overall switching cycle of the switch transistor in the photovoltaic inverter is lower. In addition, the direct current conversion circuit and the inverter circuit in the photovoltaic inverter may further include an additional resistor or an additional inductor. By adding the additional resistor or the additional inductor, impedance of a transmission line between the drive units in the direct current conversion circuit and in the inverter circuit is much greater than impedance of a connection line between the corresponding switch transistors (or a ratio of impedance of a transmission line between the drive units to impedance of a connection line between the switch transistors may be not less than a preset impedance ratio), so that a power current shunted and outputted by the Kelvin emitter or the Kelvin source is reduced when the four-pin switch transistor in the direct current conversion circuit and the inverter circuit is turned on or turned off, which prevents the power current shunted and outputted by the Kelvin emitter or the Kelvin source of the four-pin switch transistor in the photovoltaic inverter from affecting the build-up of the drive voltage of the switch transistor and the switching speed of the switch transistor, reducing a working loss of the photovoltaic inverter. Therefore, the photovoltaic inverter has strong working reliability.

## Claims

1. An inverter circuit, wherein the inverter circuit comprises a plurality of inverter units, a drive power supply, and a plurality of drive units, wherein each inverter unit comprises a plurality of switch transistors (Q1_A, Q2_A, Q3_A, Q4_A; Q1_B, Q2_B, Q3_B, Q4_B; Q1_C, Q2_C, Q3_C, Q4_C), the switch transistor are IGBTs, a first input end and a second input end of each drive unit are respectively connected to a positive electrode (Vdrv+) and a negative electrode (Vdrv0) of the drive power supply, and an output end of any drive unit is connected to a Gate (G) of a target switch transistor (Q4_A, Q4_B, Q4_C) in a plurality of switch transistors of an inverter unit associated with the any drive unit;
the inverter circuit further comprises a first direct current capacitor (Cbus_n) and a second direct current capacitor (Cbus_p) that are connected in series, an emitter (E) of a target switch transistor (Q4_A, Q4_B, Q4_C) in any inverter unit is commonly grounded and connected to the first direct current capacitor (Cbus_n), and a collector (C) of the target switch transistor (Q4_A, Q4_B, Q4_C) in the any inverter unit is connected to the second direct current capacitor (Cbus_p) by using one switch transistor (Q1_A; Q1_B; Q1_C) in the any inverter unit and is connected to connection ends of the first direct current capacitor (Cbus_n) and the second direct current capacitor (Cbus_p) by using two switch transistors (Q2_A, Q3_A; Q2_B, Q3_B; Q2_C, Q3_C) connected in series in the any inverter unit; and
a target switch transistor comprised in at least one of the plurality of inverter units is a four-pin switch transistor, a fourth end of the four-pin switch transistor is a Kelvin emitter (K) coupled to a first input end and a second input end of a target drive unit connected to the at least one inverter unit, the fourth end is coupled to the first input end by using a first capacitor (C1n) and coupled to the second input end by using a second capacitor (C2n), and the Kelvin emitter (K) of the four-pin switch transistor is configured to separate a power current outputted from the emitter (E) of the four-pin switch transistor and a drive voltage applied by the target drive unit, to avoid interference on the drive voltage caused by parasitic inductance generated based on the power current, wherein each inverter unit further comprises an additional resistor or an additional inductor, and a first input end and a second input end of the any drive unit are coupled to a first input end and a second input end of another drive unit by using the additional resistor or additional inductor.

2. A photovoltaic inverter, wherein the photovoltaic inverter comprises the inverter circuit according to claim 1 and a direct current conversion circuit, wherein the direct current conversion circuit comprises a plurality of direct current conversion units connected in parallel, an output capacitor comprising the first direct current capacitor (Cbus_n) of the inverter circuit and the second direct current capacitor (Cbus_p) of the inverter circuit, and a plurality of drive units, wherein each direct current conversion unit comprises a switch transistor (Q1; Q2; Qn), an inductor (L 1; L2; Ln), and a diode (D1; D2; Dn), the switch transistor is an IGBT, a first input end and a second input end of each drive unit of the direct current conversion circuit are respectively connected to the positive electrode (Vdrv+) and the negative electrode (Vdrv0) of the drive power supply, an output end of one drive unit of the direct current conversion circuit is connected to a gate (G) of a switch transistor (Q1; Q2; Qn) in one direct current conversion unit, an emitter (E) of the switch transistor is grounded, and a collector (C) of the switch transistor is connected to a direct current power supply (Vdc) by using the inductor (L1; L2; Ln) and is connected to the output capacitor by using the diode (D1; D2; Dn); wherein a switch transistor (Q1; Q2; Qn) comprised in at least one of the plurality of direct current conversion units is a four-pin switch transistor, a fourth end of the four-pin switch transistor is a Kelvin emitter (K) coupled to a first input end and a second input end of a target drive unit connected to the at least one direct current conversion unit, the fourth end is coupled to the first input end by using a first capacitor (C1n) and coupled to the second input end by using a second capacitor (C2n), and the Kelvin emitter (K) of the four-pin switch transistor is configured to separate a power current outputted from the emitter (E) of the four-pin switch transistor and a drive voltage applied by the target drive unit, to avoid interference on the drive voltage caused by parasitic inductance generated based on the power current, and an output end of the inverter circuit is configured to couple to an alternating current power grid, wherein each direct current conversion unit further comprises an additional resistor or an additional inductor, and a first input end and a second input end of any drive unit of the direct current conversion circuit are coupled to a first input end and a second input end of another drive unit by using the additional resistor or additional inductor.

## Patentansprüche

1. Wechselrichterschaltung, wobei die Wechselrichterschaltung mehrere Wechselrichtereinheiten, eine Ansteuerstromversorgung und mehrere Ansteuereinheiten umfasst, wobei jede Wechselrichtereinheit mehrere Schalttransistoren (Q1_A, Q2_A, Q3_A, Q4_A; Q1_B, Q2_B, Q3_B, Q4_B; Q1_C, Q2_C, Q3_C, Q4_C) umfasst, die Schalttransistoren IGBTs sind, ein erstes Eingangsende und ein zweites Eingangsende jeder Ansteuereinheit mit einer positiven Elektrode (Vdrv+) bzw. einer negativen Elektrode (Vdrv0) der Ansteuerstromversorgung verbunden sind und ein Ausgangsende einer beliebigen Ansteuereinheit mit einem "Gate" (G) eines Zielschalttransistors (Q4_A, Q4_B, Q4_C) in mehreren Schalttransistoren einer Wechselrichtereinheit verbunden ist, die mit der beliebigen Ansteuereinheit verknüpft ist;
die Wechselrichterschaltung ferner einen ersten Gleichstromkondensator (Cbus_n) und einen zweiten Gleichstromkondensator (Cbus_p) umfasst, die in Reihe geschaltet sind, ein Emitter (E) eines Zielschalttransistors (Q4_A, Q4_B, Q4_C) in einer beliebigen Wechselrichtereinheit gemeinsam geerdet und mit dem ersten Gleichstromkondensator (Cbus_n) verbunden ist und ein Kollektor (C) des Zielschalttransistors (Q4_A, Q4_B, Q4_C) in der beliebigen Wechselrichtereinheit mit dem zweiten Gleichstromkondensator (Cbus_p) mittels eines Schalttransistors (Q1_A; Q1_B; Q1_C) in der beliebigen Wechselrichtereinheit verbunden ist und mit Anschlussenden des ersten Gleichstromkondensators (Cbus_n) und des zweiten Gleichstromkondensators (Cbus_p) mittels zweier in Reihe geschalteter Schalttransistoren (Q2_A, Q3_A; Q2_B, Q3_B; Q2_C, Q3_C) in der beliebigen Wechselrichtereinheit verbunden ist; und
ein Zielschalttransistor, der in mindestens einer der mehreren Wechselrichtereinheiten enthalten ist, ein Vierpol-Schalttransistor ist, ein viertes Ende des Vierpol-Schalttransistors ein Kelvin-Emitter (K) ist, der mit einem ersten Eingangsende und einem zweiten Eingangsende einer Zielansteuereinheit gekoppelt ist, die mit der mindestens einen Wechselrichtereinheit verbunden ist, das vierte Ende mit dem ersten Eingangsende mittels eines ersten Kondensators (C1n) und mit dem zweiten Eingangsende mittels eines zweiten Kondensators (C2n) gekoppelt ist und der Kelvin-Emitter (K) des Vierpol-Schalttransistors dazu ausgelegt ist, einen vom Emitter (E) des Vierpol-Schalttransistors ausgegebenen Leistungsstrom und eine von der Zielansteuereinheit angelegte Ansteuerspannung zu trennen, um eine Störung der Ansteuerspannung durch eine basierend auf dem Leistungsstrom erzeugte parasitäre Induktivität zu vermeiden, wobei jede Wechselrichtereinheit ferner einen zusätzlichen Widerstand oder eine zusätzliche Induktivität umfasst und ein erstes Eingangsende und ein zweites Eingangsende der beliebigen Ansteuereinheit mit einem ersten Eingangsende und einem zweiten Eingangsende einer anderen Ansteuereinheit mittels des zusätzlichen Widerstands oder der zusätzlichen Induktivität gekoppelt sind.

2. Photovoltaik-Wechselrichter, wobei der Photovoltaik-Wechselrichter die Wechselrichterschaltung nach Anspruch 1 und eine Gleichstrom-Wandlerschaltung umfasst, wobei die Gleichstrom-Wandlerschaltung mehrere parallel geschaltete Gleichstrom-Wandlereinheiten, einen Ausgangskondensator, der den ersten Gleichstromkondensator (Cbus_n) der Wechselrichterschaltung und den zweiten Gleichstromkondensator (Cbus_p) der Wechselrichterschaltung umfasst, und mehrere Ansteuereinheiten umfasst, wobei jede Gleichstrom-Wandlereinheit einen Schalttransistor (Q1; Q2; Qn), eine Induktivität (L1; L2; Ln) und eine Diode (D1; D2; Dn) umfasst, der Schalttransistor ein IGBT ist, ein erstes Eingangsende und ein zweites Eingangsende jeder Ansteuereinheit der Gleichstrom-Wandlerschaltung jeweils mit der positiven Elektrode (Vdrv+) bzw. der negativen Elektrode (Vdrv0) der Ansteuerstromversorgung verbunden sind, ein Ausgangsende einer Ansteuereinheit der Gleichstrom-Wandlerschaltung mit einem Gate (G) eines Schalttransistors (Q1; Q2; Qn) in einer Gleichstrom-Wandlereinheit verbunden ist, ein Emitter (E) des Schalttransistors geerdet ist und ein Kollektor (C) des Schalttransistors mittels der Induktivität (L1; L2; Ln) mit einer Gleichstromversorgung (Vdc) verbunden ist und mittels der Diode (D1; D2; Dn) mit dem Ausgangskondensator verbunden ist; wobei ein Schalttransistor (Q1; Q2; Qn), der in mindestens einer der mehreren Gleichstrom-Wandlereinheiten enthalten ist, ein Vierpol-Schalttransistor ist, ein viertes Ende des Vierpol-Schalttransistors ein Kelvin-Emitter (K) ist, der mit einem ersten Eingangsende und einem zweiten Eingangsende einer Zielansteuereinheit gekoppelt ist, die mit der mindestens einen Gleichstrom-Wandlereinheit verbunden ist, das vierte Ende mit dem ersten Eingangsende mittels eines ersten Kondensators (C1n) und mit dem zweiten Eingangsende mittels eines zweiten Kondensators (C2n) gekoppelt ist und der Kelvin-Emitter (K) des Vierpol-Schalttransistors dazu ausgelegt ist, einen vom Emitter (E) des Vierpol-Schalttransistors ausgegebenen Leistungsstrom und eine von der Zielansteuereinheit angelegte Ansteuerspannung zu trennen, um eine Störung der Ansteuerspannung durch eine basierend auf dem Leistungsstrom erzeugte parasitäre Induktivität zu vermeiden, und ein Ausgangsende der Wechselrichterschaltung dazu ausgelegt ist, mit einem Wechselstromnetz gekoppelt zu werden, wobei jede Gleichstrom-Wandlereinheit ferner einen zusätzlichen Widerstand oder eine zusätzliche Induktivität umfasst und ein erstes Eingangsende und ein zweites Eingangsende einer beliebigen Ansteuereinheit der Gleichstrom-Wandlereinheit mit einem ersten Eingangsende und einem zweiten Eingangsende einer anderen Ansteuereinheit mittels des zusätzlichen Widerstands oder der zusätzlichen Induktivität gekoppelt sind.

## Revendications

1. Circuit onduleur, le circuit onduleur comprenant une pluralité d'unités d'onduleur, une alimentation de puissance d'excitation et une pluralité d'unités d'excitation, dans lequel chaque unité d'onduleur comprend une pluralité de transistors de commutation (Q1_A, Q2_A, Q3_A, Q4_A ; Q1_B, Q2_B, Q3_B, Q4_B ; Q1_C, Q2_C, Q3_C, Q4_C), les transistors de commutation sont des IGBT, une première extrémité d'entrée et une seconde extrémité d'entrée de chaque unité d'excitation sont respectivement connectées à une électrode positive (Vdrv+) et une électrode négative (Vdrv0) de l'alimentation de puissance d'excitation, et une extrémité de sortie de n'importe quelle unité d'excitation est connectée à une grille (G) d'un transistor de commutation cible (Q4_A, Q4_B, Q4_C) dans une pluralité de transistors de commutation d'une unité d'onduleur associée à n'importe quelle unité d'excitation ;
le circuit onduleur comprend en outre un premier condensateur à courant continu (Cbus_n) et un second condensateur à courant continu (Cbus_p) connectés en série, un émetteur (E) d'un transistor de commutation cible (Q4_A, Q4_B, Q4_C) dans n'importe quelle unité d'onduleur est mis à une terre commune et connecté au premier condensateur à courant continu (Cbus_n), et un collecteur (C) du transistor de commutation cible (Q4_A, Q4_B, Q4_C) dans n'importe quelle unité d'onduleur est connecté au second condensateur à courant continu (Cbus_p) à l'aide d'un transistor de commutation (Q1_A ; Q1_B ; Q1_C) dans la n'importe quelle unité d'onduleur et est connecté à des extrémités de connexion du premier condensateur à courant continu (Cbus_n) et du second condensateur à courant continu (Cbus_p) à l'aide de deux transistors de commutation (Q2_A, Q3_A ; Q2_B, Q3_B ; Q2_C, Q3_C) connectés en série dans la n'importe quelle unité d'onduleur ; et
un transistor de commutation cible compris dans au moins une de la pluralité d'unités d'onduleur est un transistor de commutation à quatre broches, une quatrième extrémité du transistor de commutation à quatre broches est un émetteur Kelvin (K) couplé à une première extrémité d'entrée et une seconde extrémité d'entrée d'une unité d'excitation cible connectée à l'au moins une unité d'onduleur, la quatrième extrémité est couplée à la première extrémité d'entrée à l'aide d'un premier condensateur (C1n) et couplée à la seconde extrémité d'entrée à l'aide d'un second condensateur (C2n), et l'émetteur Kelvin (K) du transistor de commutation à quatre broches est configuré pour séparer un courant de puissance délivré par l'émetteur (E) du transistor de commutation à quatre broches et une tension d'excitation appliquée par l'unité d'excitation cible, pour éviter sur la tension d'excitation des interférences causées par une inductance parasite générée sur la base du courant de puissance, dans lequel chaque unité d'onduleur comprend en outre une résistance supplémentaire ou une bobine d'induction supplémentaire, et une première extrémité d'entrée et une seconde extrémité d'entrée de la n'importe quelle unité d'excitation sont couplées à une première extrémité d'entrée et une seconde extrémité d'entrée d'une autre unité d'excitation à l'aide de la résistance supplémentaire ou de la bobine d'induction supplémentaire.

2. Onduleur photovoltaïque, l'onduleur photovoltaïque comprenant le circuit onduleur selon la revendication 1 et un circuit de conversion de courant continu, dans lequel le circuit de conversion de courant continu comprend une pluralité d'unités de conversion de courant continu connectées en parallèle, un condensateur de sortie comprenant le premier condensateur à courant continu (Cbus_n) du circuit onduleur et le second condensateur à courant continu (Cbus_p) du circuit onduleur, et une pluralité d'unités d'excitation, dans lequel chaque unité de conversion de courant continu comprend un transistor de commutation (Q1 ; Q2 ; Qn), une bobine d'induction (L1 ; L2 ; Ln), et une diode (D1 ; D2 ; Dn), le transistor de commutation est un IGBT, une première extrémité d'entrée et une seconde extrémité d'entrée de chaque unité d'excitation du circuit de conversion de courant continu sont respectivement connectées à l'électrode positive (Vdrv+) et à l'électrode négative (Vdrv0) de l'alimentation de puissance d'excitation, une extrémité de sortie d'une unité d'excitation du circuit de conversion de courant continu est connectée à une grille (G) d'un transistor de commutation (Q1 ; Q2 ; Qn) dans une unité de conversion de courant continu, un émetteur (E) du transistor de commutation est mis à la terre, et un collecteur (C) du transistor de commutation est connecté à une alimentation en courant continu (Vdc) à l'aide de la bobine d'induction (L1 ; L2 ; Ln) et est connecté au condensateur de sortie à l'aide de la diode (D1 ; D2 ; Dn) ; dans lequel un transistor de commutation (Q1 ; Q2 ; Qn) compris dans au moins une de la pluralité d'unités de conversion de courant continu est un transistor de commutation à quatre broches, une quatrième extrémité du transistor de commutation à quatre broches est un émetteur Kelvin (K) couplé à une première extrémité d'entrée et une seconde extrémité d'entrée d'une unité d'excitation cible connectée à l'au moins une unité de conversion de courant continu, la quatrième extrémité est couplée à la première extrémité d'entrée à l'aide d'un premier condensateur (C1n) et couplée à la seconde extrémité d'entrée à l'aide d'un second condensateur (C2n), et l'émetteur Kelvin (K) du transistor de commutation à quatre broches est configuré pour séparer un courant de puissance délivré par l'émetteur (E) du transistor de commutation à quatre broches et une tension d'excitation appliquée par l'unité d'excitation cible, pour éviter sur la tension d'excitation des interférences causées par une inductance parasite générée sur la base du courant de puissance, et une extrémité de sortie du circuit onduleur est configurée pour être couplée à un réseau de puissance à courant alternatif, dans lequel chaque unité de conversion de courant continu comprend en outre une résistance supplémentaire ou une bobine d'induction supplémentaire, et une première extrémité d'entrée et une seconde extrémité d'entrée de n'importe quelle unité d'excitation du circuit de conversion de courant continu sont couplées à une première extrémité d'entrée et une seconde extrémité d'entrée d'une autre unité d'excitation à l'aide de la résistance supplémentaire ou de la bobine d'induction supplémentaire.
